(19) Europäisches Patentamt
European Patent Office
Office européen des brevets

(11) **EP 4 779 338 A1**

(12) **EUROPEAN PATENT APPLICATION**

(43) Date of publication:
**22.07.2026 Bulletin 2026/30**

(21) Application number: **25224657.4**

(22) Date of filing: **17.12.2025**

(51) International Patent Classification (IPC):
*G01R 31/389* (2019.01)

(52) Cooperative Patent Classification (CPC):
**G01R 31/389**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.01.2025 KR 20250001795**

(71) Applicant: **Samsung SDI Co., Ltd.**
**Yongin-si, Gyeonggi-do 17084 (KR)**

(72) Inventors:
• **SHIN, Euichol**
**17084 Yongin-si, Gyeonggi-do (KR)**

• **RYU, Ji-Hyun**
**17084 Yongin-si, Gyeonggi-do (KR)**
• **KA, Bokhyun**
**17084 Yongin-si, Gyeonggi-do (KR)**
• **LEE, Jong-Sook**
**17084 Yongin-si, Gyeonggi-do (KR)**
• **JEONG, Daeho**
**17084 Yongin-si, Gyeonggi-do (KR)**
• **KIM, Ho**
**17084 Yongin-si, Gyeonggi-do (KR)**

(74) Representative: **Gulde & Partner**
**Patent- und Rechtsanwaltskanzlei mbB**
**Berliner Freiheit 2**
**10785 Berlin (DE)**

(54) **METHOD AND APPARATUS FOR ANALYZING IMPEDANCE OF LITHIUM-ION BATTERY**

(57) Disclosed are a method and apparatus for analyzing impedance of a lithium-ion battery. The method according to embodiments includes a transmission line model (TLM) equivalent circuit fitting operation of analyzing measured impedance data and fitting the analyzed impedance data to a TLM equivalent circuit. The TLM equivalent circuit fitting operation includes deriving, through a complex nonlinear least square (CNLS) method, a value at which a difference between an analytical function of the TLM equivalent circuit and the measurement data is minimized. The method according to embodiments may further include a data verification operation of verifying the measured impedance data using a Kramers-Kronig relation.

EP 4 779 338 A1

**Description**

**FIELD**

The present disclosure relates to a method and apparatus for analyzing impedance of a lithium-ion battery.

**BACKGROUND**

Recently, with rapid proliferation of electronic devices using batteries, such as mobile phones, notebook computers, and electric vehicles, demand for high-capacity secondary batteries with high energy density has been rapidly increasing. Accordingly, research and development for improving performance of lithium secondary batteries has been actively conducted. Lithium secondary batteries are batteries that include a positive electrode and a negative electrode each including an active material capable of intercalation and deintercalation of lithium ions, and an electrolyte. Lithium secondary batteries generate electrical energy through oxidation and reduction reactions that occur as lithium ions are intercalated into and deintercalated from the positive electrode and the negative electrode.

**SUMMARY**

The invention is defined by the appended claims. The description that follows is subject to this limitation. Any disclosure lying outside the scope of said claims is only intended for illustrative as well as comparative purposes.

Embodiments of the present disclosure are directed to providing a method and apparatus for analyzing impedance of a lithium-ion battery, which are implemented by employing an analytical function rather than using numerical simulation.

An apparatus for analyzing impedance of a lithium-ion battery according to embodiments of the present disclosure includes a transmission line model (TLM) equivalent circuit fitting component configured to analyze measured impedance data and fit the analyzed impedance data to a TLM equivalent circuit.

In embodiments, the TLM equivalent circuit fitting component may derive, through a complex nonlinear least square (CNLS) method, a value at which a difference between an analytical function of the TLM equivalent circuit and measurement data is minimized.

In embodiments, the analytical function of the TLM equivalent circuit may include a lumped Nernst-Planck electrolyte impedance in pores $Z_2$, the impedance $Z_2$ including a liquid-phase diffusion resistance.

When $R_{liq}$ denotes a liquid-phase diffusion resistance, $C_{liq}$ denotes a liquid-phase diffusion capacitance, and $t^+$ denotes a lithium-ion transference number, the lumped Nernst-Planck electrolyte impedance $Z_2$ in pores may be represented by the following equation:

$$Z_2 = \cfrac{1}{\cfrac{1}{X_1} + \cfrac{1}{X_2 + \cfrac{1}{j\omega C_{liq,0} + \cfrac{1}{X_1 + \cfrac{1}{j\omega C_{liq,1}}} + \cfrac{1}{X_2 + \cfrac{1}{j\omega C_{liq,2}}}}}},$$

where $X_1$ is defined as $X_1 = \frac{R_{liq}}{t^+}$, and $X_2$ is defined as $X_2 = \frac{R_{liq}}{1-t^+}$. When $N_1$ denotes a constant experimentally derived based on porosity and a quantity of electrolyte, $N_2$ denotes a constant experimentally derived based on a concentration of cations, and $N_3$ denotes a constant experimentally derived based on a concentration of anions, liquid-phase diffusion capacitances $C_{liq,0}$, $C_{liq,1}$, and $C_{liq,2}$ may be represented by the following equations:

$$C_{liq,0} \approx C_{liq}/N_1$$

$$C_{liq,1} \approx \frac{1}{N_2} \frac{C_{liq}}{N_1}$$

$$C_{liq,2} \approx \frac{2}{N_3} \frac{C_{liq}}{N_1} .$$

In embodiments, when $R_{liq}$ denotes a liquid-phase diffusion resistance component, and $C_{liq}$ denotes a liquid-phase diffusion capacitance component, the lumped Nernst-Planck electrolyte impedance $Z_2$ in pores may be represented by the following equation:

$$Z_2 = \frac{1}{\frac{1}{X_1} + \frac{1}{X_2 + \frac{1}{2 \cdot jw \, C_{liq}}}} ,$$

where $X_1$ is defined as $X_1 = \frac{R_{liq}}{t^+}$ , $X_2$ is defined as $X_2 = \frac{R_{liq}}{1-t^+}$ , and $t^+$ denotes a lithium-ion transference number.

In embodiments, the analytical function of the TLM equivalent circuit may include a Barsoukov model impedance $Z_1$ and a Barsoukov model admittance $Y_3$. The Barsoukov model admittance $Y_3$ may include a solid-phase diffusion impedance component.

In embodiments, when $R_{ct}$ denotes a charge transfer resistance, $C_{dl}$ denotes an electric double-layer capacitance, and $Z_w$ denotes a solid-phase diffusion impedance, the Barsoukov model admittance $Y_3$ may be represented by the following equation:

$$Y_3 = jw \, C_{dl} + \frac{1}{R_{ct} + Z_w} .$$

In embodiments, the apparatus may further include a data verification component configured to verify whether the measured impedance data is suitable for analysis. In this case, the TLM equivalent circuit fitting component may fit data verified by the data verification component to the TLM equivalent circuit.

In embodiments, the data verification component may verify the measured impedance data using a Kramers-Kronig relation.

In embodiments, the apparatus may further include a data measurement component configured to measure the impedance of the lithium-ion battery using a set jig. The data measurement component may acquire, under varying conditions, measurement data according to temperature, measurement data according to a state of charge (SOC), measurement data according to a state of health (SOH), and measurement data according to pressure.

A method of analyzing impedance of a lithium-ion battery according to embodiments of the present disclosure includes a transmission line model (TLM) equivalent circuit fitting operation of analyzing measured impedance data and fitting the analyzed impedance data to a TLM equivalent circuit.

In embodiments, the TLM equivalent circuit fitting operation may include deriving, through a complex nonlinear least square (CNLS) method, a value at which a difference between an analytical function of the TLM equivalent circuit and measurement data is minimized.

In embodiments, the analytical function of the TLM equivalent circuit may include a lumped Nernst-Planck electrolyte impedance in pores $Z_2$, the impedance $Z_2$ including a liquid-phase diffusion resistance.

When $R_{liq}$ denotes a liquid-phase diffusion resistance, $C_{liq}$ denotes a liquid-phase diffusion capacitance, and $t^+$ denotes a lithium-ion transference number, the lumped Nernst-Planck electrolyte impedance $Z_2$ in pores may be represented by the following equation:

$$Z_2 = \cfrac{1}{\cfrac{1}{X_1} + \cfrac{1}{X_2 + \cfrac{1}{j\omega C_{liq,0} + \cfrac{1}{X_1 + \cfrac{1}{j\omega C_{liq,1}}} + \cfrac{1}{X_2 + \cfrac{1}{j\omega C_{liq,2}}}}}},$$

where $X_1$ is defined as $X_1 = \frac{R_{liq}}{t^+}$, and $X_2$ is defined as $X_2 = \frac{R_{liq}}{1-t^+}$. When $N_1$ denotes a constant experimentally derived based on porosity and a quantity of electrolyte, $N_2$ denotes a constant experimentally derived based on a concentration of cations, and $N_3$ denotes a constant experimentally derived based on a concentration of anions, liquid-phase diffusion capacitances $C_{liq,0}$, $C_{liq,1}$, and $C_{liq,2}$ may be represented by the following equations:

$$C_{liq,0} \approx C_{liq}/N_1$$

$$C_{liq,1} \approx \frac{1}{N_2} \frac{C_{liq}}{N_1}$$

$$C_{liq,2} \approx \frac{2}{N_3} \frac{C_{liq}}{N_1}.$$

In embodiments, when $R_{liq}$ denotes a liquid-phase diffusion resistance component, and $C_{liq}$ denotes a liquid-phase diffusion capacitance component, the lumped Nernst-Planck electrolyte impedance $Z_2$ in pores may be represented by the following equation:

$$Z_2 = \cfrac{1}{\cfrac{1}{X_1} + \cfrac{1}{X_2 + \cfrac{1}{2 \cdot jw\, C_{liq}}}},$$

where $X_1$ is defined as $X_1 = \frac{R_{liq}}{t^+}$, $X_2$ is defined as $X_2 = \frac{R_{liq}}{1-t^+}$, and $t^+$ denotes a lithium-ion transference number.

In embodiments, the analytical function of the TLM equivalent circuit may include a Barsoukov model impedance $Z_1$ and a Barsoukov model admittance $Y_3$. The Barsoukov model admittance $Y_3$ may include a solid-phase diffusion impedance component.

In embodiments, when $R_{ct}$ denotes a charge transfer resistance, $C_{dl}$ denotes an electric double-layer capacitance, and $Z_w$ denotes a solid-phase diffusion impedance, the Barsoukov model admittance $Y_3$ may be represented by the following equation:

$$Y_3 = jw\, C_{dl} + \frac{1}{R_{ct} + Z_W}.$$

In embodiments, the method may further include a data verification operation of verifying whether the measured impedance data is suitable for analysis. The TLM equivalent circuit fitting operation may include fitting data verified in the data verification operation to the TLM equivalent circuit. In embodiments, the data verification operation may include verifying the measured impedance data using a Kramers-Kronig relation.

In embodiments, the method may include a data measurement operation of measuring the impedance of the lithium-ion battery using a set jig. In embodiments, the data measurement operation may include acquiring, under varying conditions, measurement data according to temperature, measurement data according to a state of charge (SOC), measurement data according to a state of health (SOH), and measurement data according to pressure. According to the present disclosure, a method and apparatus for analyzing impedance of a lithium-ion battery, implemented using an analytical function, may be provided. Furthermore, according to the present disclosure, a low-frequency diffusion resistance may be divided into a liquid-phase diffusion resistance and a solid-phase diffusion resistance and derived through the analytical function. In addition, according to the present disclosure, impedance factors of the lithium-ion battery may be derived more accurately.

Aspects and features of the present disclosure are not limited to those described herein, and other aspects and features not specifically mentioned herein will be clearly understood by those skilled in the art from the description of the present disclosure herein.

## BRIEF DESCRIPTION OF THE DRAWINGS

The following drawings attached to this specification illustrate preferred embodiments of the present disclosure, and help to further understand the technical spirit of the present disclosure along with the aforementioned contents of the disclosure. Accordingly, the present disclosure should not be construed as being limited to only contents described in such drawings:

FIG. 1 is a cross-sectional view of a cylindrical secondary battery;
FIG. 2 schematically illustrates a prismatic battery.
FIG. 3 schematically illustrates a pouch-type battery.
FIG. 4 schematically illustrates a pouch-type battery.
FIG. 5 is a block diagram illustrating a configuration of an apparatus for analyzing impedance of a lithium-ion battery, according to the present disclosure;
FIG. 6 is an equivalent circuit diagram of a transmission line model (TLM) used for lithium-ion battery impedance analysis according to the present disclosure;
FIG. 7 is a flowchart illustrating an operation flow of a method of analyzing impedance of a lithium-ion battery, according to the present disclosure;
FIG. 8 is a graph comparing an analysis result acquired using a Randle model and an analysis result acquired using the TLM; and
FIG. 9 is a circuit diagram illustrating an equivalent circuit used in the Randle model.

## DETAILED DESCRIPTION

Exemplary embodiments of the present disclosure will be described herein in detail with reference to the accompanying drawings. Prior to the description, it is noted that the terms or words used in this specification and claims should not be construed as being limited to common or dictionary meanings but instead should be understood to have meanings and concepts in agreement with the spirit of the present disclosure based on the principle that an inventor can define the concept of each term suitably in order to describe his/her own disclosure in the best way possible. Accordingly, since the embodiments described in this specification and the configurations illustrated in the drawings are only an example of the present disclosure and they do not cover all the technical ideas of the present disclosure, it should be understood that various changes and modifications may be made at the time of filing this application.

It will be further understood that the terms "comprises/includes" and/or "comprising/including" when used herein, specify the presence of stated features, integers, steps, operations, elements, components, and/or groups thereof, but do not preclude the presence or addition of one or more other features, integers, steps, operations, elements, components, and/or groups thereof.

In order to facilitate understanding of the present disclosure, the accompanying drawings are not drawn to scale and the dimensions of some components may be exaggerated. It should be noted that the same reference numerals are designated to the same components in different embodiments. Reference to two compared elements, features, etc. as being "the same" means that they are "substantially the same". Therefore, the phrase "substantially the same" may include a deviation that is considered low in the art, for example, a deviation of 5% or less. The uniformity of any parameter in a given region may mean that it is uniform from an average perspective.

Although the terms such as "first" and/or "second" are used to describe various components, these components are not limited by these terms, of course. These terms are only used to distinguish one component from another component. Thus, unless specifically stated to the contrary, a first component may be termed a second component without departing from the teachings of exemplary embodiments.

Throughout the specification, unless otherwise stated, each element may be singular or plural.

Arrangement of any component "above (or below)" or "on (or under)" a component may mean that any component is disposed in contact with the upper (or lower) surface of the component, as well as that other components may be interposed between the element and any element disposed on (or under) the element.

It will be understood that, when a component is referred to as being "connected", "coupled", or "joined" to another component, not only can it be directly "connected", "coupled", or "joined" to the other element, but also can it be indirectly "connected", "coupled", or "joined" to the other element with other elements interposed therebetween.

As used herein, the term "and/or" includes any and all combinations of one or more of the associate listed items. The use of "may" when describing embodiments of the present disclosure relates to "one or more embodiments of the present disclosure". Expressions such as "at least one" and "one or more" preceding a list of elements modify the entire list of elements and do not modify the individual elements in the list.

Throughout the specification, when "A and/or B" is stated, it means A, B, or A and B, unless otherwise stated. In addition, when "C to D" is stated, it means C or more and D or less, unless specifically stated to the contrary.

When the phrase such as "at least one of A, B, and C", "at least one of A, B, or C", "at least one selected from the group of A, B, and C", or "at least one selected from among A, B, and C" is used to designate a list of elements A, B, and C, the phrase may refer to any and all suitable combinations.

The term "use" may be considered synonymous with the term "utilize". As used herein, the terms "substantially," "about," and similar terms are used as terms of approximation rather than as terms of degree, and are intended to account for inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, component, region, layer, or section discussed herein may be termed a second element, component, region, layer, or section without departing from the teachings of exemplary embodiments.

For ease of explanation in describing the relationship of one element or feature to another element(s) or feature(s) as illustrated in the drawings, spatially relative terms such as "beneath", "below", "lower", "above", and "upper" may be used herein. It will be understood that spatially relative positions are intended to encompass different directions of the device in use or operation in addition to the direction depicted in the drawings. For example, if the device in the drawings is turned over, any element described as being "below" or "beneath" another element would then be oriented "above" or "over" another element. Therefore, the term "below" may encompass both upward and downward directions.

The terminology used herein is for the purpose of describing embodiments of the present disclosure and is not intended to limit the present disclosure.

A lithium secondary battery is a battery that includes an anode containing an active material capable of intercalation and deintercalation of lithium ions, a cathode and an electrolyte, and produces electrical energy through oxidation and reduction reactions when lithium ions are intercalated/deintercalated in the cathode and anode.

Although various equivalent circuits are used to analyze impedance of lithium-ion battery (LIB) full cells, many equivalent circuits are applied without sufficient physical basis. For example, the impedance of lithium-ion batteries is mostly fitted using a Randle-type equivalent circuit. However, recent research trends indicate that utilizing an equivalent circuit based on a transmission line model (TLM) reflects physical characteristics more accurately. However, in currently available literature, TLM-based equivalent circuits are mostly utilized at a level close to numerical simulation approaches rather than through analytical function fitting, thereby presenting limitations in practical application.

Positive Electrode Active Material

The positive electrode active material may include a compound (lithiated intercalation compound) that is capable of intercalating and deintercalating lithium. Specifically, at least one of a composite oxide of lithium and a metal selected from cobalt, manganese, nickel, and combinations thereof may be used.

The composite oxide may be a lithium transition metal composite oxide. Specific examples of the composite oxide may include lithium nickel-based oxide, lithium cobalt-based oxide, lithium manganese-based oxide, lithium iron phosphate-based compound, cobalt-free nickel-manganese-based oxide, or a combination thereof.

As an example, the following compounds represented by any one of the following Chemical Formulas may be used. $Li_aA_{1-b}X_bO_{2-c}D_c$ ($0.90 \leq a \leq 1.8$, $0 \leq b \leq 0.5$, and $0 \leq c \leq 0.05$) ; $Li_aMn_{2-b}X_bO_{4-c}D_c$ ($0.90 \leq a \leq 1.8$, $0 \leq b \leq 0.5$, and $0 \leq c \leq 0.05$); $Li_aNi_{1-b-c}Co_bX_cO_2-\alpha D_\alpha$ ($0.90 \leq a \leq 1.8$, $0 \leq b \leq 0.5$, $0 \leq c \leq 0.5$, and $0 < \alpha < 2$); $Li_aNi_{1-b-c}Mn_bX_cO_2-\alpha D\alpha$ ($0.90 \leq a \leq 1.8$, $0 \leq b \leq 0.5$, $0 \leq c \leq 0.5$, and $0 < \alpha < 2$) ; $Li_aNi_bCo_cL1_dG_eO_2$ ($0.90 \leq a \leq 1.8$, $0 \leq b \leq 0.9$, $0 \leq c \leq 0.5$, $0 \leq d \leq 0.5$, and $0 \leq e \leq 0.1$); $Li_aNiG_bO_2$ ($0.90 \leq a \leq 1.8$ and $0.001 \leq b \leq 0.1$); $Li_aCoG_bO_2$ ($0.90 \leq a \leq 1.8$ and $0.001 \leq b \leq 0.1$); $Li_aMn_{1-b}G_bO_2$ ($0.90 \leq a \leq 1.8$ and $0.001 \leq b \leq 0.1$); $Li_aMn_2G_bO_4$ ($0.90 \leq a \leq 1.8$ and $0.001 \leq b \leq 0.1$); $Li_aMn_{1-g}G_gPO_4$ ($0.90 \leq a \leq 1.8$ and $0 \leq g \leq 0.5$); $Li(3-f)Fe_2(PO_4)_3$ ($0 \leq f \leq 2$); or $Li_aFePO_4$ ($0.90 \leq a \leq 1.8$).

In the herein Chemical Formulas, A is Ni, Co, Mn, or a combination thereof; X is Al, Ni, Co, Mn, Cr, Fe, Mg, Sr, V, a rare earth element or a combination thereof; D is O, F, S, P, or a combination thereof; G is Al, Cr, Mn, Fe, Mg, La, Ce, Sr, V, or a combination thereof; and L1 is Mn, Al, or a combination thereof.

The positive electrode active material may be, for example, a high nickel-based positive electrode active material having a nickel content of greater than or equal to about 80 mol%, greater than or equal to about 85 mol%, greater than or equal to about 90 mol%, greater than or equal to about 91 mol%, or greater than or equal to about 94 mol% and less than or equal to about 99 mol% based on 100 mol% of the metal excluding lithium in the lithium transition metal composite oxide. The high-nickel-based positive electrode active material may be capable of realizing high capacity and can be applied to a high-capacity, high-density rechargeable lithium battery.

Positive Electrode

A positive electrode for a rechargeable lithium battery may include a current collector and a positive electrode active material layer on the current collector. The positive electrode active material layer may include a positive electrode active material and may further include a binder and/or a conductive material(e.g., an electrically conductive material).

For example, the positive electrode may further include an additive that can serve as a sacrificial positive electrode.

An amount of the positive electrode active material may be about 90 wt% to about 99.5 wt% based on 100 wt% of the positive electrode active material layer. Amounts of the binder and the conductive material may be about 0.5 wt% to about 5 wt%, respectively, based on 100 wt% of the positive electrode active material layer.

The binder serves to attach the positive electrode active material particles well to each other and also to attach the positive electrode active material well to the current collector. Examples of the binder may include polyvinyl alcohol, carboxymethyl cellulose, hydroxypropyl cellulose, diacetyl cellulose, polyvinylchloride, carboxylated polyvinylchloride, polyvinylfluoride, a polymer including ethylene oxide, polyvinylpyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, nylon, and the like, as non-limiting examples.

The conductive material may be used to impart conductivity(e.g., electrical conductivity) to the electrode. Any material that does not cause chemical change(e.g., does not cause an undesirable chemical change in the rechargeable lithium battery) and conducts electrons can be used in the battery. Examples of the conductive material may include a carbon-based material such as natural graphite, artificial graphite, carbon black, acetylene black, ketjen black, a carbon fiber, a carbon nanofiber, and carbon nanotube; a metal-based material containing copper, nickel, aluminum, silver, etc., in a form of a metal powder or a metal fiber; a conductive polymer such as a polyphenylene derivative; or a mixture thereof.

Al may be used as the current collector, but is not limited thereto.

Negative Electrode Active Material

The negative electrode active material may include a material that reversibly intercalates/deintercalates lithium ions, a lithium metal, a lithium metal alloy, a material capable of doping/dedoping lithium, or a transition metal oxide.

The material that reversibly intercalates/deintercalates lithium ions may include a carbon-based negative electrode active material, such as, for example. crystalline carbon, amorphous carbon or a combination thereof. The crystalline carbon may be graphite such as non-shaped, sheet-shaped, flake-shaped, sphere-shaped, or fiber-shaped natural graphite or artificial graphite. The amorphous carbon may be a soft carbon, a hard carbon, a mesophase pitch carbonization product, calcined coke, and the like.

The lithium metal alloy includes an alloy of lithium and a metal selected from Na, K, Rb, Cs, Fr, Be, Mg, Ca, Sr, Si, Sb, Pb, In, Zn, Ba, Ra, Ge, Al, and Sn.

The material capable of doping/dedoping lithium may be a Si-based negative electrode active material or a Sn-based negative electrode active material. The Si-based negative electrode active material may include silicon, a silicon-carbon composite, $SiO_x$ ($0 < x < 2$), a Si-Q alloy (where Q is selected from an alkali metal, an alkaline-earth metal, a Group 13 element, a Group 14 element (excluding Si), a Group 15 element, a Group 16 element, a transition metal, a rare earth element, and a combination thereof). The Sn-based negative electrode active material may include Sn, $SnO_2$, a Sn-based alloy, or a combination thereof.

The silicon-carbon composite may be a composite of silicon and amorphous carbon. According to an embodiment, the silicon-carbon composite may be in a form of silicon particles and amorphous carbon coated on the surface of the silicon particles. For example, the silicon-carbon composite may include a secondary particle (core) in which primary silicon particles are assembled, and an amorphous carbon coating layer (shell) on the surface of the secondary particle. The amorphous carbon may also be between the primary silicon particles, and, for example, the primary silicon particles may be coated with the amorphous carbon. The secondary particle may exist dispersed in an amorphous carbon matrix.

The silicon-carbon composite may further include crystalline carbon. For example, the silicon-carbon composite may include a core including crystalline carbon and silicon particles and an amorphous carbon coating layer on a surface of the core.

The Si-based negative electrode active material or the Sn-based negative electrode active material may be used in combination with a carbon-based negative electrode active material.

Negative Electrode

The negative electrode for a rechargeable lithium battery may include a current collector and a negative electrode active material layer on the current collector. The negative electrode active material layer may include a negative electrode active material, and may further include a binder and/or a conductive material (e.g., an electrically conductive material).

For example, the negative electrode active material layer may include about 90 wt% to about 99 wt% of the negative electrode active material, about 0.5 wt% to about 5 wt% of the binder, and about 0 wt% to about 5 wt% of the conductive material.

The binder may serve to attach the negative electrode active material particles well to each other and also to attach the negative electrode active material well to the current collector. The binder may include a non-aqueous binder, an aqueous binder, a dry binder, or a combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, poly amideimide, polyimide, or a combination thereof.

The aqueous binder may be selected from a styrene-butadiene rubber, a (meth)acrylated styrene-butadiene rubber, a (meth)acrylonitrile-butadiene rubber, (meth)acrylic rubber, a butyl rubber, a fluoro rubber, polyethylene oxide, polyvinylpyrrolidone, polyepichlorohydrine, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resins, polyvinyl alcohol, and a combination thereof.

When an aqueous binder is used as the negative electrode binder, a cellulose-based compound capable of imparting viscosity may be further included. The cellulose-based compound may include at least one of carboxymethyl cellulose, hydroxypropylmethyl cellulose, methyl cellulose, or an alkali metal salt thereof. The alkali metal may include Na, K, or Li.

The dry binder may be a polymer material that is capable of being fibrous. For example, the dry binder may be polytetrafluoroethylene, polyvinylidene fluoride, a polyvinylidene fluoride-hexafluoropropylene copolymer, polyethylene oxide, or a combination thereof.

The conductive material may be used to impart conductivity(e.g., electrical conductivity) to the electrode. Any material that does not cause chemical change(e.g., does not cause an undesirable chemical change in the rechargeable lithium battery) and that conducts electrons can be used in the battery. Non-limiting examples thereof may include a carbon-based material such as natural graphite, artificial graphite, carbon black, acetylene black, ketjen black, a carbon fiber, a carbon nanofiber, and a carbon nanotube; a metal-based material including copper, nickel, aluminum, silver, etc. in a form of a metal powder or a metal fiber; a conductive polymer such as a polyphenylene derivative; or a mixture thereof.

The negative current collector may include a copper foil, a nickel foil, a stainless steel foil, a titanium foil, a nickel foam, a copper foam, a polymer substrate coated with a conductive metal, or a combination thereof.

Electrolyte Solution

The electrolyte solution for a rechargeable lithium battery may include a non-aqueous organic solvent and a lithium salt.

The non-aqueous organic solvent may serve as a medium for transmitting ions taking part in the electrochemical reaction of a battery.

The non-aqueous organic solvent may be a carbonate-based, ester-based, ether-based, ketone-based, or alcohol-based solvent, an aprotic solvent, or a combination thereof.

The carbonate-based solvent may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like.

The ester-based solvent may include methyl acetate, ethyl acetate, n-propyl acetate, dimethyl acetate, methyl propionate, ethyl propionate, decanolide, mevalonolactone, valerolactone, caprolactone, and the like.

The ether-based solvent may include dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone, and the like. The alcohol-based solvent may include ethanol, isopropyl alcohol, and the like and the aprotic solvent may include nitriles such as R-CN (wherein R is a C2 to C20 linear, branched, or cyclic hydrocarbon group, a double bond, an aromatic ring, or an ether bond, and the like; amides such as dimethylformamide; dioxolanes such as 1,3-dioxolane, 1,4-dioxolane, and the like; sulfolanes, and the like.

The non-aqueous organic solvents may be used alone or in combination of two or more.

In addition, when using a carbonate-based solvent, a cyclic carbonate and a chain carbonate may be mixed and used, and the cyclic carbonate and the chain carbonate may be mixed in a volume ratio of about 1:1 to about 1:9.

The lithium salt dissolved in the organic solvent supplies lithium ions in a battery, enables a basic operation of a rechargeable lithium battery, and improves transportation of the lithium ions between positive and negative electrodes. Examples of the lithium salt include at least one selected from $LiPF_6$, $LiBF_4$, $LiSbF_6$, $LiAsF_6$, $LiClO_4$, $LiAlO_2$, $LiAlCl_4$, $LiPO_2F_2$, $LiCl$, $LiI$, $LiN(SO_3C_2F_5)_2$, $Li(FSO_2)_2N$ (lithium bis(fluorosulfonyl)imide, LiFSI), $LiC_4F_9SO_3$, $LiN(C_xF_{2x+1}SO_2)(C_yF_{2y+1}SO_2)$ (wherein x and y are integers of 1 to 20), lithium trifluoromethane sulfonate, lithium tetrafluoroethanesulfonate, lithium difluorobis(oxalato)phosphate (LiDFOB), and lithium bis(oxalato) borate (LiBOB).

Separator

Depending on the type of the rechargeable lithium battery, a separator may be present between the positive electrode and the negative electrode. The separator may include polyethylene, polypropylene, polyvinylidene fluoride, or a multilayer film of two or more layers thereof, and a mixed multilayer film such as a polyethylene/polypropylene two-layer separator, polyethylene/polypropylene/polyethylene three-layer separator, polypropylene/polyethylene/polypropylene three-layer separator, and the like.

The separator may include a porous substrate and a coating layer including an organic material, an inorganic material, or a combination thereof on one or both surfaces of the porous substrate.

The porous substrate may be a polymer film formed of any one selected polymer polyolefin such as polyethylene and polypropylene, polyester such as polyethylene terephthalate and polybutylene terephthalate, polyacetal, polyamide, polyimide, polycarbonate, polyether ketone, polyarylether ketone, polyether ketone, polyetherimide, polyamideimide, polybenzimidazole, polyethersulfone, polyphenylene oxide, a cyclic olefin copolymer, polyphenylene sulfide, polyethylene naphthalate, a glass fiber, TEFLON, and polytetrafluoroethylene, or a copolymer or mixture of two or more thereof.

The organic material may include a polyvinylidene fluoride-based polymer or a (meth)acrylic polymer.

The inorganic material may include inorganic particles selected from $Al_2O_3$, $SiO_2$, $TiO_2$, $SnO_2$, $CeO_2$, $MgO$, $NiO$, $CaO$, $GaO$, $ZnO$, $ZrO_2$, $Y_2O_3$, $SrTiO_3$, $BaTiO_3$, $Mg(OH)_2$, boehmite, and a combination thereof, but is not limited thereto.

The organic material and the inorganic material may be mixed in one coating layer, or a coating layer including an organic material and a coating layer including an inorganic material may be stacked.

Rechargeable Lithium Battery

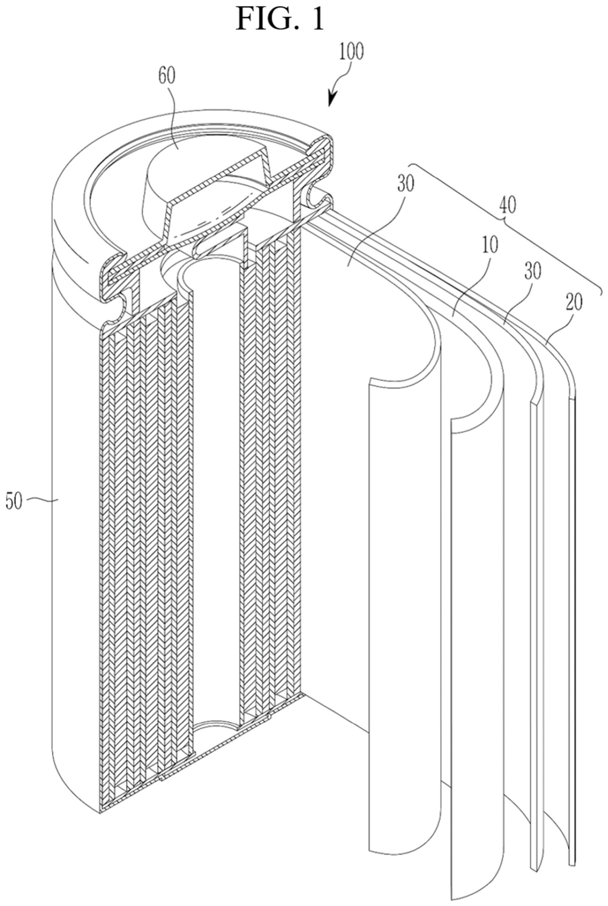

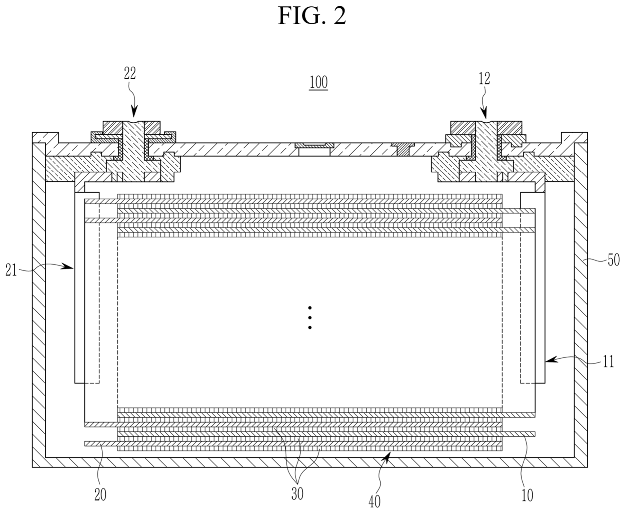

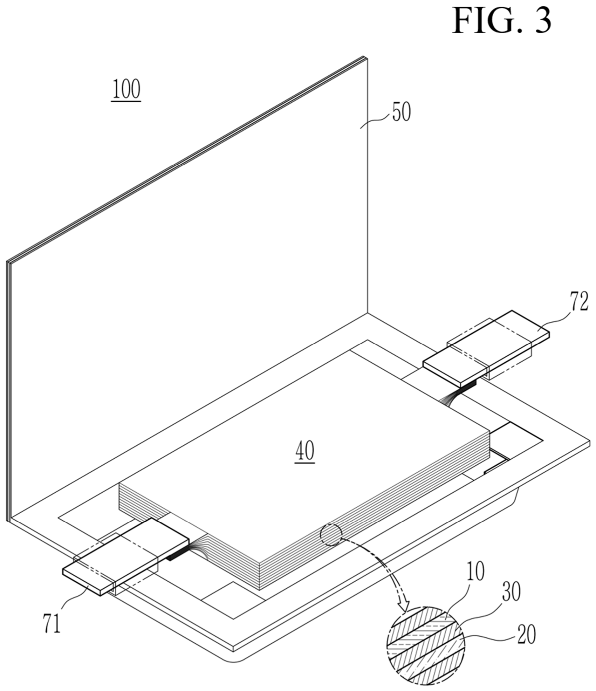

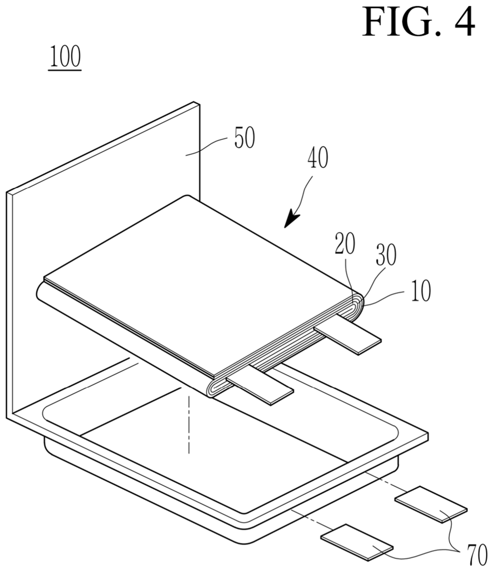

The rechargeable lithium battery may be classified into cylindrical, prismatic, pouch, or coin-type batteries, and the like depending on their shape. FIGS. 1 to 4 are schematic views illustrating a rechargeable lithium battery according to an embodiment. FIG. 1 shows a cylindrical battery, FIG. 2 shows a prismatic battery, and FIGS. 3 and 4 show pouch-type batteries. Referring to FIGS. 1 to 4, the rechargeable lithium battery 100 may include an electrode assembly 40 including a separator 30 between a positive electrode 10 and a negative electrode 20, and a case 50 in which the electrode assembly 40 is included. The positive electrode 10, the negative electrode 20, and the separator 30 may be impregnated with an electrolyte solution (not shown). The rechargeable lithium battery 100 may include a sealing member 60 sealing the case 50, as shown in FIG. 1. In FIG. 2, the rechargeable lithium battery 100 may include a positive lead tab 11, a positive terminal 12, a negative lead tab 21, and a negative terminal 22. As shown in FIGS. 3 and 4, the rechargeable lithium battery 100 may include an electrode tab 70, which may be, for example, a positive electrode tab 71 and a negative electrode tab 72 serving as an electrical path for inducing the current formed in the electrode assembly 40 to the outside.

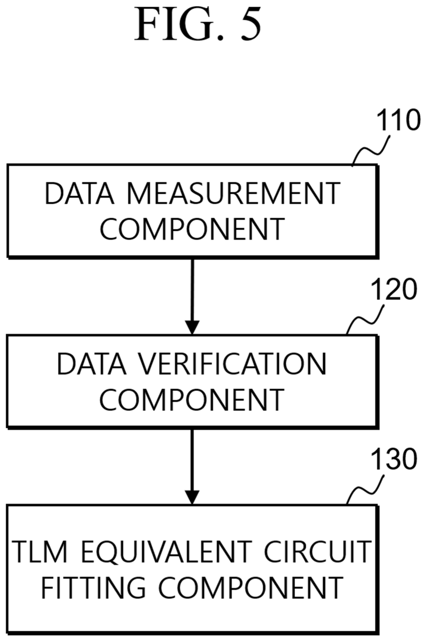

FIG. 5 is a block diagram illustrating a configuration of an apparatus for analyzing impedance of a lithium-ion battery, according to the present disclosure.

The lithium-ion battery impedance analysis apparatus according to embodiments of the present disclosure includes a data measurement component 110 configured to measure the impedance of the lithium-ion battery, a data verification component 120 configured to verify the measured impedance data, and a transmission line model (TLM) equivalent circuit fitting component 130 configured to analyze the impedance data that has passed verification and fit the impedance data to a TLM equivalent circuit.

The data measurement component 110 may measure the impedance of the lithium-ion battery using a predetermined jig. In embodiments, the jig may include a negative electrode current line, a positive electrode current line, a negative electrode voltage line, and a positive electrode voltage line. The impedance may be measured by connecting the negative electrode current line and the negative electrode voltage line of the jig to a negative electrode terminal of a battery cell, and connecting the positive electrode current line and the positive electrode voltage line of the jig to a positive electrode terminal of the battery cell. The impedance may be measured in a predetermined frequency range. For example, the impedance may be measured in a frequency range from 1 MHz to 1 mHz.

Furthermore, the impedance may be measured under various conditions. In other words, measurement data according to temperature, measurement data according to a state of charge (SOC), measurement data according to a state of health (SOH), and measurement data according to pressure may be acquired under varying conditions. For example, the measurement data according to temperature may be acquired by measuring the impedance while changing the ambient temperature from -10°C to 45°C. The measurement data according to the SOC may be acquired by measuring the impedance at SOC values ranging from 0% to 100%. The measurement data according to the SOH may be acquired by measuring the impedance at SOH values ranging from 100% to 60%. The measurement data according to pressure may be acquired by measuring the impedance under pressure ranging from 0 MPa to 3 MPa.

In embodiments, instead of the data measurement component 110, a data input component configured to receive pre-measured data may be provided.

The data verification component 120 may verify whether measured data is suitable for analysis. The verification of whether the measured data is suitable for analysis may be performed, for example, using a Kramers-Kronig (KK) relation. In other words, the data may be verified by performing a KK test.

The Kramers-Kronig relation may be a bidirectional mathematical relation that connects the real and imaginary parts of a complex function analyzable in the upper half-plane. In the case of a stable system, causality may imply conditions of analyticity, and conversely, analyticity may imply causality of a corresponding stable physical system. Accordingly, the KK test may be used to verify whether the measured data has been acquired in a manner suitable for analysis.

The TLM equivalent circuit fitting component 130 may derive, through a complex nonlinear least square (CNLS) method, a value at which a difference between an analytical function of a TLM equivalent circuit and measurement data is minimized.

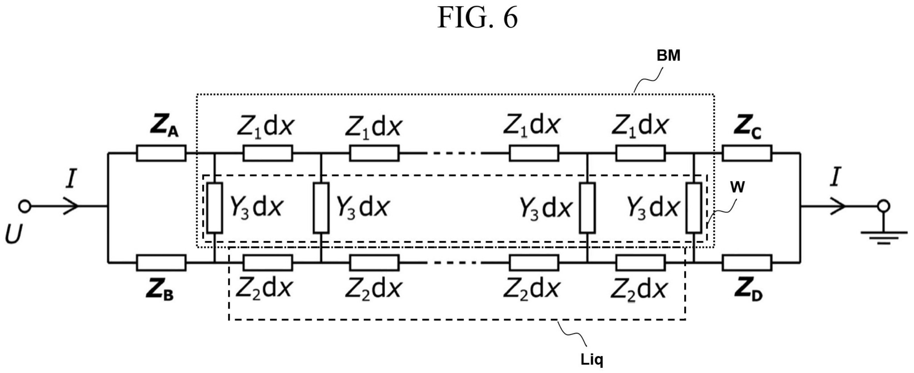

FIG. 6 illustrates a transmission line model (TLM) equivalent circuit. In FIG. 6, $Z_A$ may denote a contact resistance, $Z_B$ may denote an interfacial Warburg element, BM may denote a Barsoukov model, $Z_2$ may denote a lumped Nernst-Planck electrolyte impedance in pores, $Z_C$ may denote a contact capacitance, and $Z_D$ may denote a lumped Nernst-Planck electrolyte impedance in a separator. In

FIG. 6, a box labeled "$L_{iq}$" may indicate a region including a liquid-phase impedance component, and a box labeled "W" may indicate a region including a solid-phase impedance component.

In embodiments, because the contact resistance $Z_A$, the impedance $Z_1$ of the Barsoukov model, and the contact capacitance ZC are close to zero, the contact resistance $Z_A$, the impedance $Z_1$, and the contact capacitance $Z_C$ may be assumed to be zero for calculation, as shown in Equation 1.

$$[\text{Equation 1}]$$

$$Z_A = Z_C = Z_1 \fallingdotseq 0$$

In embodiments, the contact resistance $Z_A$ may be calculated as R (contact resistance), the contact capacitance $Z_C$ may be calculated as $1/j\omega C$ (contact capacitance), and the impedance $Z_1$ of the Barsoukov model may be calculated as $1/(1/R + 1/j\omega L)$. The impedance $Z_1$ represents a stray effect at high frequencies.

The lumped Nernst-Planck electrolyte impedance in pores $Z_2$ may be expressed by Equation 2. As can be seen from Equation 2, the lumped Nernst-Planck electrolyte impedance $Z_2$ in pores may include a liquid-phase diffusion resistance component $R_{liq}$ and a liquid-phase diffusion capacitance component $C_{liq}$.

[Equation 2]

$$Z_2 = \cfrac{1}{\cfrac{1}{X_1} + \cfrac{1}{X_2 + \cfrac{1}{j\omega C_{liq,0} + \cfrac{1}{X_1 + \cfrac{1}{j\omega C_{liq,1}}} + \cfrac{1}{X_2 + \cfrac{1}{j\omega C_{liq,2}}}}}}$$

Here, $X_1$ may be defined as $X_1 = \frac{R_{liq}}{t^+}$, and $X_2$ may be defined as $X_2 = \frac{R_{liq}}{1-t^+}$. $C_{liq,0}$, $C_{liq,1}$, and $C_{liq,2}$ may be values that can be acquired from the liquid-phase diffusion capacitance $C_{liq}$ according to Equation 3. $t^+$ may denote the lithium-ion transference number.

$C_{liq,0}$ may correspond to a capacitance generated during diffusion caused by a concentration difference in the liquid phase. $C_{liq,1}$ may correspond to a cation-related capacitance that increases as the concentration of cations increases, and $C_{liq,2}$ may correspond to an anion-related capacitance that increases as the concentration of anions increases.

[Equation 3]

$$C_{liq,0} \approx C_{liq}/N_1$$

$$C_{liq,1} \approx \frac{1}{N_2}\frac{C_{liq}}{N_1}$$

$$C_{liq,2} \approx \frac{2}{N_3}\frac{C_{liq}}{N_1}$$

Here, $N_1$ may be a constant experimentally determined according to porosity and the amount of electrolyte, and may have a value ranging from 1 to 5. $N_2$ may be a constant experimentally determined according to the concentration of cations, and may have a value ranging from 1 to 10. $N_3$ may be a constant experimentally determined according to the concentration of anions, and may have a value ranging from 1 to 30.

In embodiments, the lumped Nernst-Planck electrolyte impedance in pores $Z_2$ may be expressed by Equation 4. As can be seen from Equation 4, the lumped Nernst-Planck electrolyte impedance $Z_2$ in pores may include the liquid-phase diffusion resistance component $R_{liq}$ and the liquid-phase diffusion capacitance component $C_{liq}$.

[Equation 4]

$$Z_2 = \cfrac{1}{\cfrac{1}{X_1} + \cfrac{1}{X_2 + \cfrac{1}{2 \cdot jw\, C_{liq}}}}$$

Here, $X_1$ may be defined as $X_1 = \frac{R_{liq}}{t^+}$, and $X_2$ may be defined as $X_2 = \frac{R_{liq}}{1-t^+}$. $t^+$ may denote the lithium-ion transference number.

An admittance $Y_3$ of the Barsoukov model may be expressed by Equation 5. As can be seen from Equation 5, the admittance $Y_3$ of the Barsoukov model may include a solid-phase diffusion impedance component $Z_w$. In Equation 5, $R_{ct}$ may denote a charge transfer resistance, and $C_{dl}$ may denote an electric double-layer capacitance.

[Equation 5]

$$Y_3 = jw\, C_{dl} + \frac{1}{R_{ct} + Z_W}$$

The TLM equivalent circuit fitting component 130 may derive parameters that minimize a difference between the analytical function of the TLM equivalent circuit expressed by Equations 1 to 3 and the measurement data, by using the complex nonlinear least square (CNLS) method.

In embodiments, the TLM equivalent circuit fitting component 130 may derive the following seven parameters through a fitting process.

$R_{ct}$ (charge transfer resistance),
$C_{dl}$ (electric double-layer capacitance),
$t^+$ (lithium-ion transference number),
$R_{liq}$ (liquid-phase diffusion resistance),
$C_{liq}$ (liquid-phase diffusion capacitance),
$R_W$ (solid-phase diffusion resistance), and
$C_W$ (solid-phase diffusion capacitance).

In embodiments, the TLM equivalent circuit fitting component 130 may be configured to derive the following eleven parameters through a fitting process. Among the parameters listed herein, six parameters ranging from charge transfer resistance to separator capacitance may be mainly present in a mid-frequency region, the solid-phase diffusion resistance and the solid-phase diffusion capacitance may be mainly present in a low-frequency region, and the liquid-phase diffusion resistance and the liquid-phase diffusion capacitance may be present across both the mid- and low-frequency regions.

$C_B$: interfacial reaction capacitance
$R_{ct}$: charge transfer resistance
$C_{dl}$: electric double-layer capacitance
$Q_{WB}$: interfacial reaction time constant
$t^+$: lithium-ion transference number
$R_{sep}$: separator resistance
$C_{sep}$: separator capacitance
$R_{liq}$: liquid-phase diffusion resistance
$C_{liq}$: liquid-phase diffusion capacitance
$R_w$: solid-phase diffusion resistance
$C_w$: solid-phase diffusion capacitance

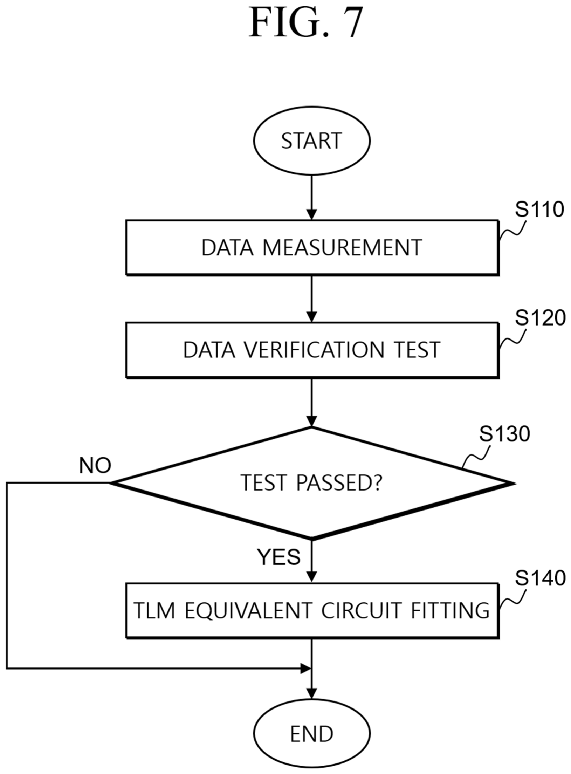

Hereinafter, a method of analyzing the impedance of the lithium-ion battery according to embodiments of the present disclosure will be described with reference to FIG. 7.

First, the impedance of the lithium-ion battery may be measured (in step S110). According to embodiments, the impedance of the lithium-ion battery may be measured by using a separate jig. The impedance may be measured in a predetermined frequency range. For example, the impedance may be measured in a frequency range from 1 MHz to 1 mHz. The impedance may also be measured under various conditions. In other words, measurement data according to temperature, measurement data according to an SOC, measurement data according to an SOH, and measurement data according to pressure may be acquired under varying conditions.

For example, the measurement data according to the temperature may be acquired by measuring the impedance while changing an ambient temperature from -10°C to 45°C. The measurement data according to the SOC may be acquired by measuring the impedance at SOC values ranging from 0% to 100%. The measurement data according to the SOH may be acquired by measuring the impedance at SOH values ranging from 100% to 60%. The measurement data according to the pressure may be acquired by measuring the impedance under pressure ranging from 0 MPa to 3 MPa.

In embodiments, the step of receiving pre-measured data may be included instead of the data measurement step S110.

Next, the measured impedance data may be verified with respect to the measured data (in step S120). In this step, whether the measured data has been acquired in a manner suitable for analysis may be verified. For example, the verification of whether the measured data is suitable for analysis may be performed using a Kramers-Kronig (KK) relation. That is, the data may be verified by performing a KK test.

The Kramers-Kronig relation may be a bidirectional mathematical relation that connects the real and imaginary parts of a complex function analyzable in the upper half-plane. In the case of a stable system, causality may imply conditions of analyticity, and conversely, analyticity may imply causality of a corresponding stable physical system. Accordingly, the KK test may be used to verify whether the measured data has been acquired in a manner suitable for analysis.

If the measured data passes the KK test ("Yes" in step S130), a TLM equivalent circuit fitting step may be performed in step S140. In the TLM equivalent circuit fitting step S140, a value at which a difference between an analytical function of a TLM equivalent circuit and measurement data is minimized may be derived by using the CNLS method.

In other words, parameters at which a difference between analytical functions $Z_A$, $Z_B$, $Z_C$, $Z_D$, $Z_1$, $Z_2$, and $Y_3$ of the TLM equivalent circuit as shown in FIG. 6 and the measurement data is minimized may be derived. In step S140, the parameters at which a difference between the analytical functions and the measurement data is minimized may be derived by using the CNLS method, the parameters including $R_{ct}$ (charge transfer resistance), $C_{dl}$ (electric double-layer capacitance), t+ (lithium-ion transference number), $R_{liq}$ (liquid-phase diffusion resistance), $C_{liq}$ (liquid-phase diffusion capacitance), $R_w$ (solid-phase diffusion resistance), and $C_w$ (solid-phase diffusion capacitance).

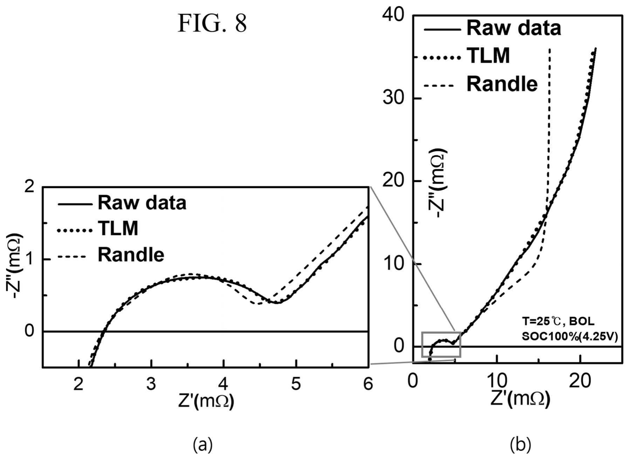

FIG. 8 illustrates a comparison between an analysis result acquired using a Randle model and an analysis result acquired using the TLM.

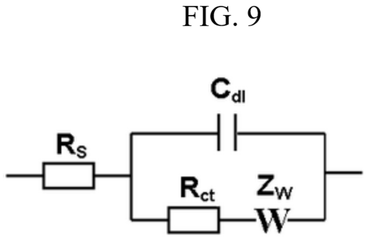

The Randle model may be formed by modeling an electrochemical reaction occurring at an electrode-electrolyte interface using an electrical circuit, and may be expressed as a circuit shown in FIG. 9. In FIG. 9, Rs may denote a resistance of an electrolyte, $C_{dl}$ may denote an electric double-layer capacitance, $R_{ct}$ may denote a charge transfer resistance, and $Z_w$ may denote a Warburg impedance.

In FIG. 8, a solid line may represent actual impedance data, a dotted line may represent an analysis result acquired using the TLM, and a dashed line may represent an analysis result acquired using the Randle model. As shown in FIG. 8, a significant difference may be observed between the actual impedance data and the analysis result acquired using the Randle model, whereas only a slight difference may be observed when using the TLM.

The foregoing may be numerically represented in Table 1. Table 1 shows the Chi-square values and sums of squares between the actual impedance data and the fitting results acquired using each model.

[Table 1]

| Fitting Results | Chi-Square | Sum of Square |
| --- | --- | --- |
| TLM | 3.16E-05 | 4.39E-03 |
| Randle | 1.87E-03 | 0.27 |

As shown in Table 1, it can be seen that errors occurring in fitting using the TLM are lower by approximately two digits compared to the Randle model, indicating that fitting using the TLM can provide significantly more accurate results.

Although the present disclosure has been described herein with respect to embodiments thereof, the present disclosure is not limited thereto. Various modifications and variations can be made by those skilled in the art within the spirit of the present disclosure and the scope of equivalence of the appended claims.

**Claims**

1. An apparatus for analyzing impedance of a lithium-ion battery, the apparatus comprising a transmission line model (TLM) equivalent circuit fitting component configured to analyze measured impedance data and fit the analyzed impedance data to a TLM equivalent circuit,
wherein the TLM equivalent circuit fitting component derives, through a complex nonlinear least square (CNLS) method, a value at which a difference between an analytical function of the TLM equivalent circuit and measurement data is minimized.

2. The apparatus as claimed in claim 1, wherein the analytical function of the TLM equivalent circuit includes a lumped Nernst-Planck electrolyte impedance in pores $Z_2$, the impedance $Z_2$ including a liquid-phase diffusion resistance.

3. The apparatus as claimed in claim 2, wherein, when $R_{liq}$ denotes a liquid-phase diffusion resistance, $C_{liq}$ denotes a liquid-phase diffusion capacitance, and $t^+$ denotes a lithium-ion transference number,

the lumped Nernst-Planck electrolyte impedance in pores $Z_2$ is represented by the following equation:

$$Z_2 = \cfrac{1}{\cfrac{1}{X_1} + \cfrac{1}{X_2 + \cfrac{1}{j\omega C_{liq,0} + \cfrac{1}{X_1 + \cfrac{1}{j\omega C_{liq,1}}} + \cfrac{1}{X_2 + \cfrac{1}{j\omega C_{liq,2}}}}}},$$

where $X_1$ is defined as $X_1 = \frac{R_{liq}}{t^+}$, and $X_2$ is defined as $X_2 = \frac{R_{liq}}{1-t^+}$, and

wherein, when $N_1$ denotes a constant experimentally derived based on porosity and a quantity of electrolyte, $N_2$ denotes a constant experimentally derived based on a concentration of cations, and $N_3$ denotes a constant experimentally derived based on a concentration of anions,
liquid-phase diffusion capacitances $C_{liq,0}$, $C_{liq,1}$, and $C_{liq,2}$ are represented by the following equations:

$$C_{liq,0} \approx C_{liq}/N_1$$

$$C_{liq,1} \approx \frac{1}{N_2}\frac{C_{liq}}{N_1}$$

$$C_{liq,2} \approx \frac{2}{N_3}\frac{C_{liq}}{N_1}.$$

4. The apparatus as claimed in claim 2, wherein, when $R_{liq}$ denotes a liquid-phase diffusion resistance component, and $C_{liq}$ denotes a liquid-phase diffusion capacitance component,

the lumped Nernst-Planck electrolyte impedance in pores $Z_2$ is represented by the following equation:

$$Z_2 = \cfrac{1}{\cfrac{1}{X_1} + \cfrac{1}{X_2 + \cfrac{1}{2 \cdot jw\, C_{liq}}}},$$

where $X_1$ is defined as $X_1 = \frac{R_{liq}}{t^+}$, $X_2$ is defined as $X_2 = \frac{R_{liq}}{1-t^+}$, and $t^+$ denotes a lithium-ion transference number.

5. The apparatus as claimed in claim 1,

    wherein the analytical function of the TLM equivalent circuit includes a Barsoukov model impedance $Z_1$ and a Barsoukov model admittance $Y_3$, and
    wherein the Barsoukov model admittance $Y_3$ includes a solid-phase diffusion impedance component.

6. The apparatus as claimed in claim 5, wherein, when $R_{ct}$ denotes a charge transfer resistance, $C_{dl}$ denotes an electric double-layer capacitance, and $Z_w$ denotes a solid-phase diffusion impedance, the Barsoukov model admittance $Y_3$ is represented by the following equation:

$$Y_3 = jw\, C_{dl} + \frac{1}{R_{ct} + Z_W}.$$

7. The apparatus as claimed in claim 1, further comprising a data verification component configured to verify whether the measured impedance data is suitable for analysis,
    wherein the TLM equivalent circuit fitting component fits data verified by the data verification component to the TLM equivalent circuit.

8. The apparatus as claimed in claim 7, wherein the data verification component verifies the measured impedance data using a Kramers-Kronig relation.

9. The apparatus as claimed in claim 1, further comprising a data measurement component configured to measure the impedance of the lithium-ion battery using a set jig.

10. The apparatus as claimed in claim 9, wherein the data measurement component acquires, under varying conditions, measurement data according to temperature, measurement data according to a state of charge (SOC), measurement data according to a state of health (SOH), and measurement data according to pressure.

11. A method of analyzing impedance of a lithium-ion battery, the method comprising a transmission line model (TLM) equivalent circuit fitting operation of analyzing measured impedance data and fitting the analyzed impedance data to a TLM equivalent circuit,
    wherein the TLM equivalent circuit fitting operation comprises deriving, through a complex nonlinear least square (CNLS) method, a value at which a difference between an analytical function of the TLM equivalent circuit and measurement data is minimized.

# FIG. 1

# FIG. 2

FIG. 3

FIG. 4

# FIG. 5

DATA MEASUREMENT COMPONENT — 110

DATA VERIFICATION COMPONENT — 120

TLM EQUIVALENT CIRCUIT FITTING COMPONENT — 130

# FIG. 6

EP 4 779 338 A1

# FIG. 7

START

DATA MEASUREMENT  S110

DATA VERIFICATION TEST  S120

TEST PASSED?  S130

NO

YES

TLM EQUIVALENT CIRCUIT FITTING  S140

END

FIG. 8

(a)

(b)

FIG. 9

Europäisches
Patentamt
European
Patent Office
Office européen
des brevets

**EUROPEAN SEARCH REPORT**

Application Number

EP 25 22 4657

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 088 240 B1 (KOREA KUMHO PETROCHEM CO LTD [KR]) 5 April 2006 (2006-04-05) | 1,5,7, 9-11 | INV. G01R31/389 |
| Y | * abstract; figures 1-10 * | 6 | |
| A | * paragraphs [0057] - [0063] * | 3,4,8 | |
| | ----- | | |
| X | CHRISTIAN PEDERSEN ET AL: "Equivalent circuit and continuum modeling of the impedance of electrolyte-filled pores", ARXIV.ORG CORNELL UNIVERSITY LIBRARY, 201 OLIN LIBRARY CORNELL UNIVERSITY ITHACA, NY 14853, 1 September 2023 (2023-09-01), XP091602465, | 1,2,11 | |
| A | * abstract * | 3,4,6, 8-10 | |
| | ----- | | |
| Y | Barsoukov: "Effect of Low-Temperature Conditions on Passive Layer Growth on Li Intercalation Materials", , 1 August 1998 (1998-08-01), pages 2711-2717, XP093406546, Retrieved from the Internet: URL:https://iopscience.iop.org/article/10.1149/1.1838703/pdf [retrieved on 2026-06-12] * the whole document * | 6 | TECHNICAL FIELDS SEARCHED (IPC) G01R |
| | ----- | | |

The present search report has been drawn up for all claims

| Place of search | Date of completion of the search | Examiner |
|---|---|---|
| Munich | 12 June 2026 | Kleiber, Michael |

EPO FORM 1503 03.82 (P04C01)

## ANNEX TO THE EUROPEAN SEARCH REPORT
## ON EUROPEAN PATENT APPLICATION NO.

EP 25 22 4657

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2026

| Patent document cited in search report | | Publication date | Patent family member(s) | | Publication date |
|---|---|---|---|---|---|
| EP 1088240 | B1 | 05-04-2006 | AT | E322695 T1 | 15-04-2006 |
| | | | CA | 2334404 A1 | 23-12-1999 |
| | | | CN | 1305590 A | 25-07-2001 |
| | | | EP | 1088240 A1 | 04-04-2001 |
| | | | IL | 140090 A | 31-05-2010 |
| | | | TW | 440698 B | 16-06-2001 |
| | | | WO | 9966340 A1 | 23-12-1999 |

EPO FORM P0459

For more details about this annex : see Official Journal of the European Patent Office, No. 12/82